# EUROPEAN PATENT APPLICATION

(11) **EP 4 503 878 A1**
(43) Date of publication of application: **05.02.2025**
(21) Application number: 24192046.1
(22) Date of filing: 31.07.2024
(51) Int. Cl.: H05K 7/14, H05K 5/06

(54) **PHOTOVOLTAIC OPTIMIZER, PACKAGE HOUSING, AND ELECTRONIC DEVICE**

(30) Priority: 31.07.2023 CN 202310960337
(71) Applicant: Huawei Digital Power Technologies Co., Ltd., Shenzhen, Guangdong 518043 (CN)
(72) Inventor: LI, Xiaozhen, Shenzhen, 518043 (CN); TANG, Qingguo, Shenzhen, 518043 (CN); CHEN, Zhangrui, Shenzhen, 518043 (CN); HUI, Ziyun, Shenzhen, 518043 (CN)
(74) Representative: Gill Jennings & Every LLP

(57) **Abstract**

A photovoltaic optimizer, a package housing, and an electronic device are disclosed. The photovoltaic optimizer includes: an upper housing and a lower housing, where a cavity is formed between the upper housing and the lower housing; and a circuit board, where the circuit board is located in the cavity, and the circuit board includes a power tracking circuit; and the upper housing includes an overflow glue groove, an opening of the overflow glue groove is located on a side that is of the upper housing and that is away from the lower housing, at least one overflow glue hole is provided at a bottom of the overflow glue groove, and the at least one overflow glue hole communicates the cavity with the overflow glue groove. The photovoltaic optimizer, the package housing, and the electronic device have a design of an overflow glue groove, so that assembly processes of the photovoltaic optimizer and the electronic device are simplified, helping reduce costs.

## Description

### TECHNICAL FIELD

This application relates to the field of electronic devices, and more specifically, to a photovoltaic optimizer, a package housing, and an electronic device.

### BACKGROUND

With development of an electronic product towards densification, miniaturization, and high power, a requirement for heat dissipation is increasingly high. Sealing the electronic product in potting glue can effectively protect an electronic device and improve heat dissipation performance. Stacking density in a cavity of the electronic product is increasingly high, and a channel through which the potting glue flows is increasingly small. How to balance filling quality and efficiency of the potting glue is an urgent problem to be resolved currently.

In a conventional solution, an overflow glue cup needs to be used to fill a product cavity with the potting glue. However, the overflow glue cup is a consumable in a product processing procedure, and there are installation and removal processes before and after glue filling respectively. Consequently, an assembly process is complex and costs are increased.

### SUMMARY

This application provides a photovoltaic optimizer, a package housing, and an electronic device. The photovoltaic optimizer, the package housing, and the electronic device have a design of an overflow glue groove, so that assembly processes of the photovoltaic optimizer and the electronic device are simplified, helping reduce costs.

According to a first aspect, a photovoltaic optimizer is provided, including: an upper housing and a lower housing, where a cavity is formed between the upper housing and the lower housing; and a circuit board, where the circuit board is located in the cavity, and the circuit board includes a power tracking circuit; and the upper housing includes an overflow glue groove, an opening of the overflow glue groove is located on a side that is of the upper housing and that is away from the lower housing, at least one overflow glue hole is provided at a bottom of the overflow glue groove, and the at least one overflow glue hole communicates the cavity with the overflow glue groove.

In this embodiment of this application, the overflow glue groove may accommodate overflowed potting glue, to provide an overflow margin for the potting glue. When being configured to accommodate the overflowed potting glue, the overflow glue hole may be further configured to exhaust gas in the cavity, so that the potting glue fills up the entire cavity, helping protect an electronic component in the cavity and facilitate heat dissipation of the electronic component. In addition, the overflow glue groove is an inherent component on the housing, and does not need to be installed or removed, so that an assembly process of a product is simplified and costs are reduced.

With reference to the first aspect, in some implementations of the first aspect, the lower housing includes a bottom plate, the circuit board is fastened to a surface that is of the bottom plate and that is close to the upper housing, a distance between the bottom of the overflow glue groove and the bottom plate in a first direction is greater than or equal to a distance between the circuit board and the bottom plate in the first direction, and the first direction is perpendicular to the bottom plate.

In this embodiment of this application, when the potting glue appears in the overflow glue groove, it may be determined that the circuit board has been covered by the potting glue. Therefore, existence of the overflow glue groove can conveniently determine a filling status of the potting glue in the cavity.

With reference to the first aspect, in some implementations of the first aspect, the lower housing includes a bottom plate, the circuit board is fastened to a surface that is of the bottom plate and that is close to the upper housing, a distance between the bottom of the overflow glue groove and the bottom plate in a first direction is greater than or equal to a distance between a surface that is of the upper housing and that is close to the bottom plate and the bottom plate in the first direction, and the first direction is perpendicular to the bottom plate.

In this embodiment of this application, the overflow glue groove may be provided at a highest location of the cavity, that is, the bottom of the overflow glue groove is flush with the highest location of the cavity. Therefore, when the overflow glue groove overflows the potting glue, it can be determined that the cavity has been filled up with the potting glue. In addition, the overflow glue hole may be configured to discharge air in the cavity, and the overflow glue hole is provided at a location that is finally filled by the potting glue of the cavity. Therefore, all gas before the cavity is filled up with the potting glue can be discharged. This helps the potting glue fill up the entire cavity.

With reference to the first aspect, in some implementations of the first aspect, at least a part of a side wall of the overflow glue groove is in contact with the cavity, the part that is of the side wall of the overflow glue groove and that is in contact with the cavity includes at least one air exhaust hole, and the at least one air exhaust hole communicates the cavity with the overflow glue groove.

In this embodiment of this application, the bottom of the overflow glue groove may be lower than a highest location of the cavity. When the potting glue enters the overflow glue groove through the overflow glue hole, air in the cavity may be further discharged through the air exhaust hole provided on the side wall of the overflow glue groove. This helps the potting glue fill up the entire cavity.

With reference to the first aspect, in some implementations of the first aspect, the upper housing or the lower housing further includes a glue filling hole, and the glue filling hole is configured to fill the cavity with the potting glue.

With reference to the first aspect, in some implementations of the first aspect, a scale is provided on an inner side wall of the overflow glue groove; and the scale is for determining whether the cavity has been filled up with the potting glue, or the scale is for determining whether the potting glue has covered the circuit board.

In this embodiment of this application, the scale is provided on the inner side wall of the overflow glue groove, helping determine the filling status of the potting glue in the cavity.

With reference to the first aspect, in some implementations of the first aspect, a plurality of heat sinks are disposed on a side that is of the lower housing and that is away from the upper housing.

In this embodiment of this application, the plurality of heat sinks disposed on the side that is of the lower housing and that is away from the upper housing may be configured to dissipate heat for the circuit board in the cavity, helping improve heat dissipation performance of the product.

With reference to the first aspect, in some implementations of the first aspect, a circuit board bracket is disposed on a surface that is of the bottom plate and that is close to the upper housing, and the circuit board bracket is configured to install the circuit board.

In this embodiment of this application, the circuit board bracket may be configured to install the circuit board, to avoid a short circuit of the circuit board, and help improve performance and stability of the product.

With reference to the first aspect, in some implementations of the first aspect, the upper housing and the lower housing form a package housing of the photovoltaic optimizer, at least one through hole is provided on a side wall of the package housing, the photovoltaic optimizer further includes at least one cable, one end of the at least one cable is connected to the circuit board, the other end of the at least one cable passes through the at least one through hole and extends to external space of the package housing, and the at least one cable is in a one-to-one correspondence with the at least one through hole.

According to a second aspect, a package housing is provided. The package housing includes an upper housing and a lower housing, where a cavity is formed between the upper housing and the lower housing; and the upper housing includes an overflow glue groove, an opening of the overflow glue groove is located on a side that is of the upper housing and that is away from the lower housing, at least one overflow glue hole is provided at a bottom of the overflow glue groove, and the at least one overflow glue hole communicates the cavity with the overflow glue groove.

It should be understood that technical effect of any one of the second aspect or the possible implementations of the second aspect are similar to technical effect of the first aspect. For details, refer to related descriptions of the first aspect. Details are not described herein again.

With reference to the second aspect, in some implementations of the second aspect, the lower housing includes a bottom plate, a distance between the bottom of the overflow glue groove and the bottom plate in a first direction is greater than or equal to a distance between a surface that is of the upper housing and that is close to the bottom plate and the bottom plate in the first direction, and the first direction is perpendicular to the bottom plate.

With reference to the second aspect, in some implementations of the second aspect, at least a part of a side wall of the overflow glue groove is in contact with the cavity, the part that is of the side wall of the overflow glue groove and that is in contact with the cavity includes at least one air exhaust hole, and the at least one air exhaust hole communicates the cavity with the overflow glue groove.

With reference to the second aspect, in some implementations of the second aspect, the upper housing or the lower housing further includes a glue filling hole, and the glue filling hole is configured to fill the cavity with potting glue.

With reference to the second aspect, in some implementations of the second aspect, a scale is provided on an inner side wall of the overflow glue groove; and the scale is for determining whether the cavity has been filled up with the potting glue, or the scale is for determining whether the potting glue has covered the circuit board.

According to a third aspect, an electronic device is provided, including a circuit board and the package housing according to any one of the second aspect and the possible implementations of the second aspect, where the circuit board is disposed in the cavity of the package housing.

With reference to the third aspect, in some implementations of the third aspect, the package housing includes the upper housing and the lower housing, the cavity is formed between the upper housing and the lower housing, the lower housing includes the bottom plate, the circuit board is fastened to a side that is of the bottom plate and that is close to the upper housing, the distance between the bottom of the overflow glue groove and the bottom plate in the first direction is greater than or equal to a distance between the circuit board and the bottom plate in the first direction, and the first direction is perpendicular to the bottom plate.

### BRIEF DESCRIPTION OF DRAWINGS

FIG. 1 is a diagram of a structure of a package housing according to an embodiment of this application;
FIG. 2 is an exploded view of the package housing shown in FIG. 1;
FIG. 3 is a diagram of a structure of a package housing according to an embodiment of this application;
FIG. 4 is a diagram of a structure of a package housing according to an embodiment of this application;
FIG. 5 is a diagram of a structure of a package housing according to an embodiment of this application;
FIG. 6 is a diagram of a structure of a photovoltaic optimizer according to an embodiment of this application;
FIG. 7 is an exploded view of the photovoltaic optimizer shown in FIG. 6; and
FIG. 8 is a diagram of a photovoltaic power generation system according to an embodiment of this application.

### DESCRIPTION OF EMBODIMENTS

The following describes technical solutions of embodiments in this application with reference to accompanying drawings.

In descriptions of embodiments of this application, "/" means "or" unless otherwise specified. For example, A/B may represent A or B. In this specification, "and/or" describes only an association relationship between associated objects, and indicates that three relationships may exist. For example, A and/or B may indicate the following three cases: Only A exists, both A and B exist, and only B exists.

In embodiments of this application, prefix words such as "first", "second", "third", "fourth", and "fifth" are used only to distinguish between different described objects, and do not limit a location, a sequence, a priority, a quantity, content, or the like of the described objects. In embodiments of this application, use of prefix words for distinguishing between described objects, such as an ordinal number, does not constitute a limitation on the described object. For a description of the described object, refer to a description of the context in the claims or embodiments, and the use of these prefix words should not constitute a redundant limitation. In addition, in description of this embodiment, unless otherwise specified, "a plurality of means two or more.

In descriptions of embodiments of this application, an orientation or a location relationship indicated by terms such as "up", "down", "inside", and "outside" is defined relative to an orientation or a location at which a component is schematically placed in the accompanying drawings. It should be understood that, these directional terms are relative concepts, which are used for relative descriptions and clarifications, instead of indicating or implying that a specified apparatus or component needs to have a specific orientation, or being constructed and operated in a specific orientation. The apparatus or component may be correspondingly changed based on a change of an orientation in which a component is placed in the accompanying drawings, and therefore cannot be construed as a limitation on this application.

Reference to "some embodiments" or the like described in this specification means that one or more embodiments of this application include a particular feature, structure, or characteristic described with reference to the embodiments. Therefore, statements such as "in some embodiments" that appear at different places in this specification do not necessarily mean reference to a same embodiment, instead, they mean "one or more but not all of embodiments", unless otherwise specifically emphasized. The terms "include", "comprise", "have", and their variants all mean "include but are not limited to", unless otherwise specifically emphasized in another manner.

"Equal to" in this application is not an equal-to in a strict sense, but is within an allowable error range. "Flush" is not tangent in a strict sense, but is within an allowable error range.

In embodiments of this application, a same reference numeral indicates a same part or a same component. In this embodiment of this application, for a plurality of same components, only one of the components may be used as an example in the accompanying drawings to mark a reference numeral. For another same part or component, the reference numeral is also applicable. In addition, dimensions and sizes of the components shown in the accompanying drawings are merely examples.

With development of an electronic product towards densification, miniaturization, and high power, a requirement for heat dissipation is increasingly high. Sealing the electronic product in potting glue can effectively protect an electronic device and improve heat dissipation performance. Stacking density in a cavity of the electronic product is increasingly high, and a channel through which the potting glue flows is increasingly small. How to balance filling quality and efficiency of the potting glue is an urgent problem to be resolved currently.

In a conventional solution, an overflow glue cup may be for accommodating overflowed potting glue. However, the overflow glue cup is a consumable in a product processing procedure, and there are installation and removal processes before and after glue filling respectively. Consequently, an assembly process is complex and costs are increased.

Embodiments of this application provide a package housing, so that an installation process of a product is simplified and costs are reduced when filling quality and efficiency of potting glue can be ensured.

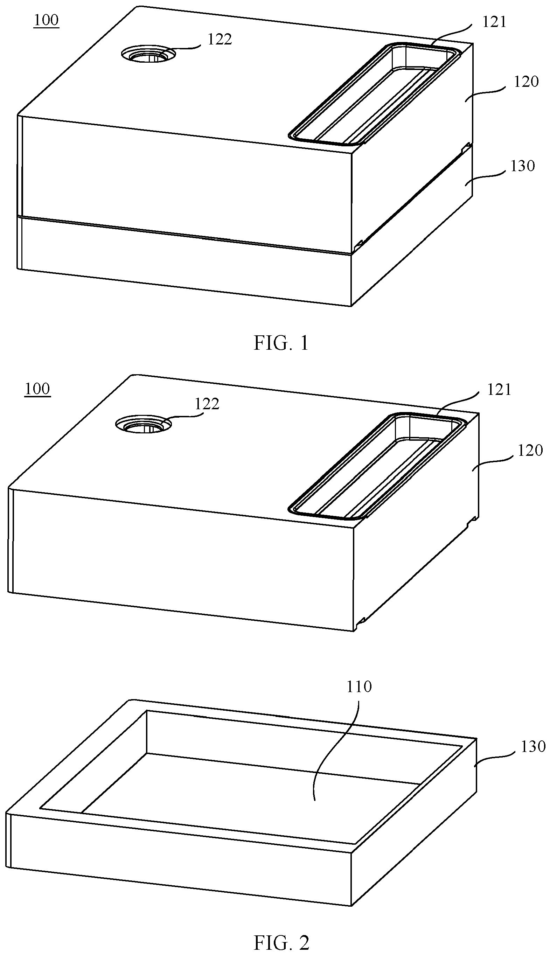

FIG. 1 is a diagram of a structure of a package housing according to an embodiment of this application. FIG. 2 is an exploded view of the package housing shown in FIG. 1.

As shown in FIG. 1 and FIG. 2, there is a cavity 110 inside the package housing 100, and the cavity 110 is configured to accommodate an electronic component. The package housing 100 may further play a role of protecting and supporting the electronic component.

The electronic component in the cavity 110 may be, for example, a printed circuit board, a chip, a battery, or an antenna. An electronic component located outside the cavity 110 may be, for example, a power supply, a photovoltaic module, or a photovoltaic inverter. A type of the electronic component is not limited in this embodiment of this application.

The following describes the printed circuit board. The printed circuit board is a support for electronic elements, and is also used as a carrier for electrical connections for the electronic elements. The printed circuit board has a function of supporting and interconnecting circuit elements. The electronic element includes but is not limited to a capacitor, an inductor, a resistor, a processor, a memory, a camera, a flash, a microphone, a battery, an antenna, or the like.

Generally, a printed circuit board on which no electronic element is soldered may be referred to as a PCB single board. A printed circuit board on which an electronic element is soldered may be referred to as a printed circuit board assembly (PCBA).

The printed circuit board may use an FR-4 dielectric board, a Rogers (Rogers) dielectric board, a hybrid dielectric board of Rogers and FR-4, or the like. Herein, FR-4 is a grade designation for a flame resistant material, and the Rogers dielectric board is a high-frequency board. The printed circuit board may be a single-sided board, a double-sided board, a multi-layer circuit board, or the like. The printed circuit board may be a ceramic circuit board, an alumina ceramic circuit board, an aluminum nitride ceramic circuit board, an aluminum substrate, a high-frequency board, a heavy copper board, an impedance board, or the like. In some embodiments, the printed circuit board may also be referred to as a main board.

Conductive patterns are disposed on the printed circuit board, and the electronic elements may be electrically connected through wiring between different conductive patterns. The printed circuit board after wiring may include a functional network and a non-functional network. The functional network may provide an electrical function, such as charging, a radio frequency, an antenna, multimedia, data storage, or a sensor. The non-functional network cannot provide an electrical function and is mainly for implementing mechanical connection between a soldered mechanical part and the PCB. The non-functional network is usually grounded (,GND) or suspended (not connected to any functional network or GND network) and is for isolating the mechanical parts carried on the printed circuit board from the functional network to avoid an electric shock or device damage caused by incorrect contact.

The electronic elements carried on the printed circuit board may form a plurality of functional modules to implement corresponding functions. For example, a charging management module is configured to receive charging input from a charger, a power management module is configured to supply power to a display and the like, a wireless communication module and a mobile communication module are configured to implement a communication function of an electronic device, and an audio module is configured to implement an audio function and the like. A shape of the printed circuit board may be correspondingly designed based on a shape of the electronic device, and locations, shapes, and the like of the functional modules to be disposed inside the electronic device.

In this embodiment of this application, the printed circuit board and the package housing 100 may be used in some electronic devices. The electronic device may be, for example, a terminal consumer product or a 3C electronic product (a computer), communication, or consumer electronic product), such as a mobile phone, a mobile power supply, a portable computer, a tablet computer, an e-reader, a notebook computer, a digital camera, a wearable device, an in-vehicle terminal, or a headset. This is not limited in this embodiment of this application.

In this embodiment of this application, the package housing 100 includes an upper housing 120 and a lower housing 130. The upper housing 120 and the lower housing 130 are disposed opposite to each other, to form the cavity of the package housing 100.

In some embodiments, a groove is provided on a side that is of the upper housing 120 and that is close to the lower housing 130. Correspondingly, a groove is also provided on a side that is of the lower housing 130 and that is close to the upper housing 120. The two grooves are provided opposite to each other, to form the cavity 110. Alternatively, a groove is provided on a side that is of the upper housing 120 and that is close to the lower housing 130, and the lower housing 130 may cover the groove, to form the cavity 110. Alternatively, a groove is provided on a side that is of the lower housing 130 and that is close to the upper housing 120, and the upper housing 120 may cover the groove, to form the cavity 110.

In other words, the upper housing 120 may include a top plate and a side wall, the side wall surrounds a periphery of the top plate, the lower housing includes a bottom plate, and the side wall of the upper housing is located between the top plate and the bottom plate. Alternatively, the lower housing 130 may include a bottom plate and a side wall, the side wall surrounds a periphery of the bottom plate, the upper housing includes a top plate, and the side wall of the lower housing is located between the top plate and the bottom plate. Alternatively, the upper housing 120 may include a top plate and a side wall, the side wall of the upper housing 120 surrounds a periphery of the top plate, the lower housing 130 may include a bottom plate and a side wall, the side wall of the lower housing 130 surrounds a periphery of the bottom plate, and side walls of the upper housing 120 and the lower housing 130 jointly form a side wall of the package housing 100.

The upper housing 120 and the lower housing 130 may be fastened together detachably, for example, in a fastening manner such as snap-fitting, riveting, screw connection, or bonding. This is not limited in this embodiment of this application.

In this embodiment of this application, the upper housing 120 may be made of a material with good formability and abrasive resistance, for example, plastic; and the lower housing 130 may be made of a metal material, for example, aluminum. Alternatively, the upper housing 120 and the lower housing 130 may be made of other materials. Materials of the upper housing 120 and the lower housing 130 are not limited in this embodiment of this application.

For ease of description, the following uses an example in which the upper housing 120 and the lower housing 130 are disposed opposite to each other in a first direction for description. The first direction is a direction perpendicular to the top plate of the upper housing 120, or the first direction is a direction perpendicular to the bottom plate of the lower housing 130. Alternatively, when the package housing 100 is horizontally placed, the first direction may be a gravity direction.

In this embodiment of this application, an overflow glue groove 121 is provided on a side that is of the upper housing 120 and that is away from the lower housing 130, and an opening of the overflow glue groove 121 is located on the side that is of the upper housing 120 and that is away from the lower housing 130. At least one overflow glue hole is provided at a bottom of the overflow glue groove 121, and the at least one overflow glue hole may communicate the cavity 110 with the overflow glue groove 121.

A glue filling hole 122 may be further provided on the upper housing 120, and is configured to fill the cavity 110 with potting glue. The potting glue may have good fluidity, insulation, heat conductivity, and the like. In this embodiment of this application, the cavity 110 may be filled up with the potting glue, so that functions such as insulation, heat conductivity, and protection on the electronic component disposed in the cavity 110 may be implemented. The potting glue may be, for example, a material such as organosilicon potting glue, polyurethane potting glue, or epoxy resin potting glue. A material of the potting glue is not limited in this embodiment of this application.

The glue filling hole 122 may be provided on the side that is of the upper housing 120 and that is away from the lower housing 130, or may be provided on a side wall of the upper housing 120. When the glue filling hole 122 is provided on the side that is of the upper housing 120 and that is away from the lower housing 130, the potting glue may flow into the cavity 110 by gravity until the entire cavity is filled up. When the glue filling hole 122 is provided on the side wall of the upper housing 120, the potting glue may need to be pressed into the cavity 110 until the entire cavity is filled up.

Due to existence of the gravity, the potting glue always first fills a bottom of the cavity 110, and gradually fills up the entire cavity 110. The overflow glue groove 121 is provided on the side that is of the upper housing 120 and that is away from the lower housing 130. When the potting glue fills up the entire cavity 110, and the potting glue is injected into the cavity 110 again, excess potting glue overflows from the at least one overflow glue hole to the overflow glue groove 121.

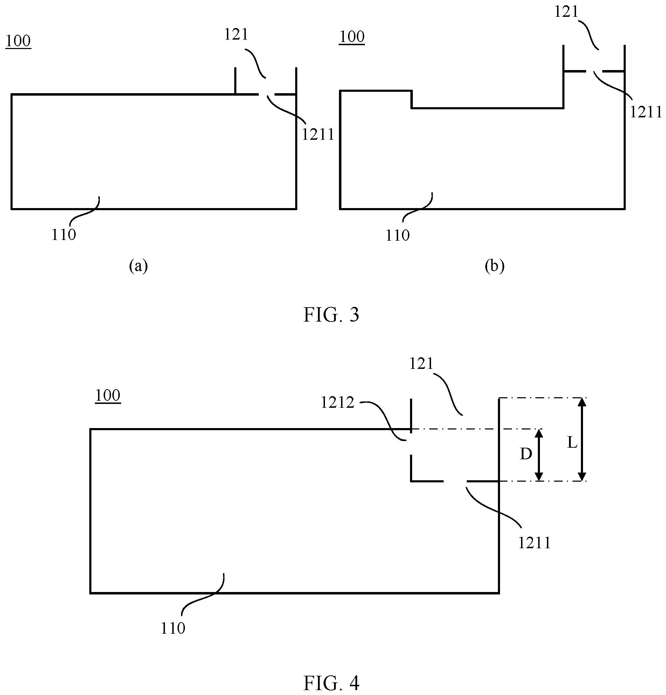

FIG. 3, FIG. 4, and FIG. 5 are diagrams of structures of package housings according to an embodiment of this application.

In some embodiments, as shown in (a) and (b) in FIG. 3, an overflow glue groove 121 may be provided at a highest location of a cavity 110, that is, a bottom of the overflow glue groove 121 is flush with the highest location of the cavity 110.

It should be noted that a height of the cavity 110 means a distance between a lower surface of an upper housing 120 and an upper surface of a lower housing 130 in a first direction. At the highest location of the cavity, there is a longest distance between the lower surface of the upper housing 120 and the upper surface of the lower housing 130 in the first direction. In other words, a distance between the bottom of the overflow glue groove 121 and a bottom plate of the lower housing 130 in the first direction may be greater than or equal to a distance between a surface that is of the upper housing 120 and that is close to the lower housing 130 and the bottom plate of the lower housing 130 in the first direction.

It should be understood that the lower surface of the upper housing 120 may not be a flush plane structure, and the distance between the surface that is of the upper housing 120 and that is close to the lower housing 130 and the bottom plate in the first direction is a maximum distance between a point on the lower surface of the upper housing 120 and the bottom plate, that is, a maximum height of the cavity.

It may be understood that air originally exists in the cavity 110. In a glue filling process, at least one overflow glue hole 1211 may also serve as an air exhaust hole, and is configured to exhaust the air in the cavity 110, to prevent bubbles from occurring in the cavity, and avoid a case in which potting glue cannot fill up the entire cavity 110.

In some embodiments, as shown in FIG. 4, a bottom of an overflow glue groove 121 may be lower than a highest location of a cavity 110. In this case, a depth L of the overflow glue groove 121 is greater than or equal to a distance D between the bottom of the overflow glue groove 121 and the highest location of the cavity 110 in a first direction.

It should be understood that when the overflow glue groove 121 is provided at the highest location of the cavity 110, the distance D is zero.

It should be understood that when the bottom of the overflow glue groove 121 is lower than the highest location of the cavity 110, at least a part of a side wall of the overflow glue groove 121 is in contact with the cavity 110.

Refer to FIG. 4. At least one air exhaust hole 1212 may be further provided on the part that is of the side wall of the overflow glue groove 121 and that is in contact with the cavity 110, and the at least one air exhaust hole 1212 may communicate the cavity 110 with the overflow glue groove 121. The at least one air exhaust hole 1212 may be provided close to the highest location of the cavity 110 as far as possible, so that when potting glue overflows from at least one overflow glue hole 1211 to the overflow glue groove 121, air in the cavity 110 may be further exhausted from the at least one air exhaust hole 1212.

Because a package housing 100 is not transparent, in a glue filling process, people cannot learn whether the cavity 110 is filled up. However, due to existence of the overflow glue groove 121, when the potting glue occurs in the overflow glue groove 121, it may be learned that the cavity 110 is filled up.

In some embodiments, a scale may be further provided on an inner side wall of the overflow glue groove 121. The scale may be for determining whether the cavity 110 has been filled up with the potting glue. To be specific, when the potting glue reaches or exceeds the scale, the cavity 110 has been filled up with the potting glue; or when the potting glue does not reach the scale, the cavity 110 is not filled up. Alternatively, the scale may be for determining whether the potting glue covers a circuit board or an electronic component in the cavity 110.

It should be understood that the scale may be an identifier, or may be an air exhaust hole. This is not limited in this embodiment of this application.

In some embodiments, a distance between the bottom of the overflow glue groove 121 and a bottom plate of a lower housing 130 in the first direction is greater than or equal to a distance between the circuit board in the cavity 110 and the bottom plate of the lower housing 130 in the first direction. In this way, when the potting glue overflows from the overflow glue groove 121, it can be determined that the potting glue has covered the circuit board.

It should be noted that the circuit board may not be a flush plane structure. The distance between the circuit board in the cavity 110 and the bottom plate of the lower housing 130 in the first direction is a distance between any point on the circuit board and the bottom plate, or means a maximum distance between a point on the circuit board and the bottom plate.

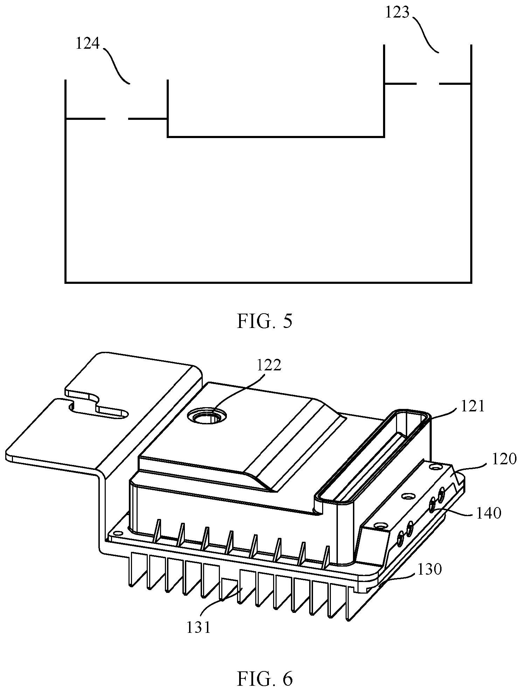

In some embodiments, as shown in FIG. 5, an upper housing 120 may be in a shape in which both ends are high and the middle is low, or in a shape in which an edge is high and the middle is low. In this case, if only one overflow glue groove is provided, a case in which a cavity 110 is not filled up may occur. Therefore, a plurality of overflow glue grooves may be provided on a side that is of the upper housing 120 and that is away from a lower housing 130. Two overflow glue grooves are used as an example for description. A first overflow glue groove 123 may be provided at a highest location of the cavity 110, and a second overflow glue groove 124 may be provided at a second highest location of the cavity 110. For specific structures of the first overflow glue groove 123 and the second overflow glue groove 124, refer to the foregoing related descriptions. Details are not described herein again.

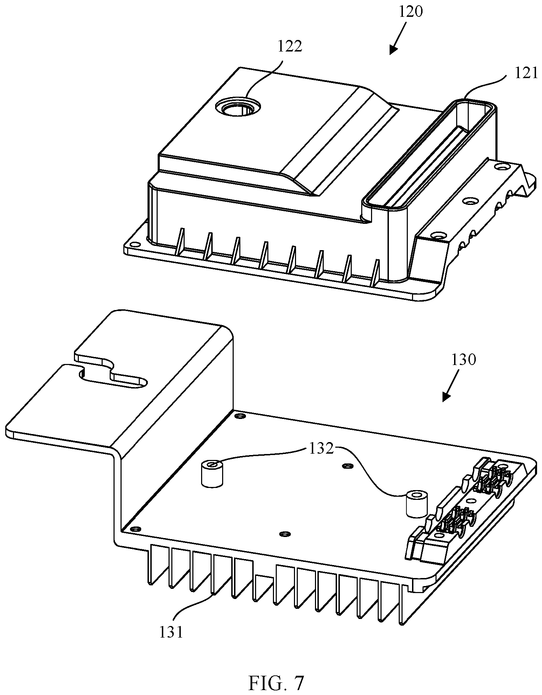

FIG. 6 is a diagram of a structure of a photovoltaic optimizer according to an embodiment of this application. FIG. 7 is an exploded view of the photovoltaic optimizer shown in FIG. 6.

In this embodiment of this application, each of package housings shown in FIG. 1 to FIG. 5 may be, for example, a housing of the photovoltaic optimizer. For a structure of the housing of the photovoltaic optimizer, refer to related descriptions of each of the package housings shown in FIG. 1 to FIG. 5. Only differences are described herein.

In this embodiment of this application, the photovoltaic optimizer may include a package housing 100 and a circuit board (not shown in the figure), and the circuit board is disposed in a cavity of the package housing 100. The circuit board may be configured to implement a function related to the photovoltaic optimizer. Specifically, a power tracking circuit may be disposed on the circuit board.

Specifically, the circuit board may be fastened to a side that is of a lower housing 130 and that is close to an upper housing 120. Refer to FIG. 7. A circuit board bracket 132 may be disposed between the circuit board and the lower housing 130, and is mainly configured to fasten the circuit board to the lower housing 130. The circuit board bracket may alternatively be an insulation bracket.

In some embodiments, refer to FIG. 6. A heat dissipation part 131 is disposed on a side that is of the lower housing 130 and that is away from the upper housing 120. A material of the heat dissipation part 131 may be a material with a high heat conductivity, for example, a metal material such as copper or aluminum, to improve heat dissipation performance.

The heat dissipation part 131 and the lower housing 130 may be of an integrated structure, or may be of a separated structure. This is not limited in this embodiment of this application. When the heat dissipation part 131 and the lower housing 130 are of the separated structure, the heat dissipation part 131 and the lower housing 130 are two different components. The heat dissipation part 131 and the lower housing 130 may be assembled together by using snap-fitting, fastening, a screw, a bolt, or the like, and may be separated when the heat dissipation part 131 and the lower housing 130 need to be disassembled. When the heat dissipation part 131 and the lower housing 130 are of the integrated structure, the heat dissipation part 131 and the lower housing 130 cannot be separated. For example, the heat dissipation part 131 and the lower housing 130 may be processed and manufactured in an integrated molding manner, or assembled and manufactured in a connection manner such as welding or riveting.

When the heat dissipation part 131 and the lower housing 130 are of the separated structure, a heat conductive layer may be disposed between the heat dissipation part 131 and the lower housing 130, to improve heat dissipation efficiency. A material of the heat conductive layer may be, for example, thermal gel or silicone grease. This is not limited in this embodiment of this application.

The heat dissipation part 131 may be a heat dissipation fin or a fin-type heat dissipation structure, to increase a heat dissipation area, thereby improving heat dissipation performance. Specifically, the heat dissipation part 131 may include a plurality of heat sinks, and each heat sink may be connected to a side that is of the lower housing 130 and that is away from the upper housing 120. Further, each heat sink may be perpendicular to a surface that is of the lower housing 130 and that is away from the upper housing 120.

In some embodiments, refer to FIG. 6. At least one through hole 140 may be provided on a side wall of a housing of the photovoltaic optimizer, to install at least one cable. The at least one cable is configured to connect an electronic component in a cavity 110 and an electronic component located outside the cavity 110. Specifically, one end that is of the at least one cable and that is located in the cavity is connected to the circuit board, the other end passes through the at least one through hole 140 and extends to external space of the package housing 100 (namely, the housing of the photovoltaic optimizer), and the other end may be connected to another electronic component such as a photovoltaic inverter or a photovoltaic module.

It should be understood that, to ensure sealing performance of the photovoltaic optimizer, each cable may correspond to one through hole, and a diameter of each cable may be the same as a diameter of the through hole.

In a possible case, the at least one through hole 140 is located on a side wall of the upper housing 120. In a possible case, the at least one through hole 140 is located on a side wall of the lower housing 130. In another possible case, a semicircular groove with an opening facing the lower housing 130 is provided on a side wall of the upper housing 120, a semicircular groove with an opening facing the upper housing 120 is provided on a side wall of the lower housing, and two semicircular grooves are provided opposite to each other to form the at least one through hole 140.

It should be understood that the at least one cable may alternatively be in a state in which the at least one cable is not connected to an external electronic component. This is not limited in this embodiment of this application.

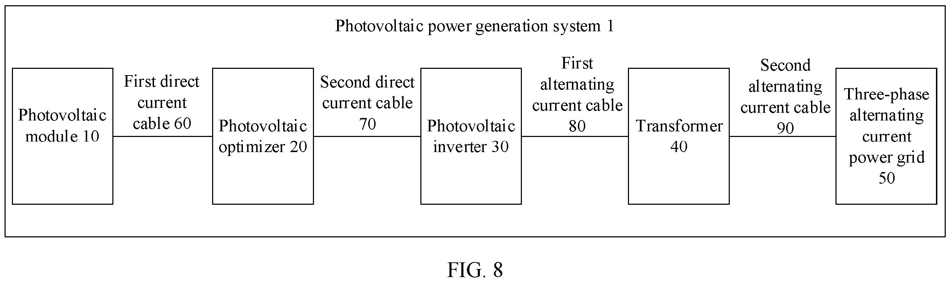

For ease of understanding, a photovoltaic power generation system is described below. FIG. 8 is a diagram of a photovoltaic power generation system according to an embodiment of this application.

As shown in FIG. 8, a photovoltaic power generation system 1 provided in this embodiment of this application includes one or more photovoltaic modules 10, one or more photovoltaic optimizers 20, a photovoltaic inverter 30, a transformer 40, a three-phase alternating current power grid 50, a first direct current cable 60, a second direct current cable 70, a first alternating current cable 80, and a second alternating current cable 90. The one or more photovoltaic modules 10 are connected to the photovoltaic optimizer 20 through the first direct current cable 60, and a connection relationship between the photovoltaic module 10 and the photovoltaic optimizer 20 may be a one-to-one connection. The one or more photovoltaic optimizers 20 are connected to the photovoltaic inverter 30 through the second direct current cable 70. The photovoltaic inverter 30 converts a direct current into an alternating current, and an alternating current side of the photovoltaic inverter 30 is connected to the transformer 40 through the first alternating current cable 80. The transformer 40 is connected to the three-phase alternating current power grid 50 through the second alternating current cable 90. In this way, an alternating current output by the photovoltaic inverter 30 flows into the three-phase alternating current power grid 50 after passing through the transformer 40. The following describes in detail each component included in the photovoltaic power generation system 1.

It should be understood that the first direct current cable 60 and the second direct current cable 70 may be, for example, an example of the at least one cable described above.

The photovoltaic power generation system is a power generation system that uses photovoltaic effect of a semiconductor material to convert solar radiation energy into electric energy. The photovoltaic power generation system provided in this embodiment of this application can enable an electric vehicle. The electric vehicle includes a pure electric vehicle (pure EV/battery EV), a hybrid electric vehicle (HEV), a range extended electric vehicle (REEV), a plug-in hybrid vehicle (HEV), a new energy vehicle (NEV), or the like.

The photovoltaic module 10 may also be referred to as a photovoltaic array, and includes a plurality of photovoltaic (PV) strings. Each photovoltaic string includes a plurality of photovoltaic panels connected in series. The photovoltaic panel is configured to convert optical energy into electric energy. The electric energy generated by the photovoltaic panel is a direct current (DC). A voltage at both ends of the photovoltaic string is equal to a sum of voltages generated by the plurality of photovoltaic panels. Output power of the photovoltaic module may represent electric energy output by the photovoltaic module in a unit time.

The photovoltaic optimizer 20 may also be referred to as a photovoltaic power optimizer and may improve power generation of the photovoltaic power generation system 1 by continuously tracking a maximum power point of each photovoltaic module 10. In addition, the photovoltaic optimizer 20 has functions such as module-level shutdown and module-level monitoring, and supports a long string design to capture a maximum power point. The photovoltaic optimizer 20 may be installed on the photovoltaic module 10. For example, the photovoltaic optimizer 20 may be installed on a profile frame of the photovoltaic module 10 through a connection plate.

The photovoltaic inverter 30 is configured to convert an input direct current into an alternating current (AC), that is, perform DC-AC conversion. The photovoltaic inverter 30 may also be referred to as a DC-AC converter.

The transformer 40 may be configured to perform voltage conversion on an alternating current, to adjust a voltage value of an input alternating current voltage. It should be understood that both input and output of the transformer 40 are alternating currents. The transformer 40 may boost alternating currents output by one or more photovoltaic inverters 30.

In the photovoltaic power generation system 1, an area of each photovoltaic module 10 is generally fixed. When light intensity of light remains unchanged, a larger included angle between light irradiating on the photovoltaic module 10 and a plane on which the photovoltaic module 10 is located, in other words, a smaller incident angle at which the light irradiates on the photovoltaic module 10, indicates more electric energy output by the photovoltaic module 10. When the light vertically irradiates on the photovoltaic module 10, in other words, the included angle between the light and the plane on which the photovoltaic module 10 is located is 90°, and reaches a maximum value, output power of the photovoltaic module 10 reaches a maximum.

When the photovoltaic power generation system 1 includes a plurality of photovoltaic optimizers 20, the photovoltaic power generation system 1 further includes a combiner box. The combiner box is configured to combine direct currents generated by the plurality of photovoltaic modules 10, and input, combined output that passes through a circuit breaker and is performed lightning protection processing, to the photovoltaic inverter 30.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A photovoltaic optimizer, comprising:
an upper housing and a lower housing, wherein a cavity is formed between the upper housing and the lower housing; and
a circuit board, wherein the circuit board is located in the cavity, and the circuit board comprises a power tracking circuit; and
the upper housing comprises an overflow glue groove, an opening of the overflow glue groove is located on a side that is of the upper housing and that is away from the lower housing, at least one overflow glue hole is provided at a bottom of the overflow glue groove, and the at least one overflow glue hole communicates the cavity with the overflow glue groove.

2. The photovoltaic optimizer according to claim 1, wherein the lower housing comprises a bottom plate, the circuit board is fastened to a side that is of the bottom plate and that is close to the upper housing, a distance between the bottom of the overflow glue groove and the bottom plate in a first direction is greater than or equal to a distance between the circuit board and the bottom plate in the first direction, and the first direction is perpendicular to the bottom plate.

3. The photovoltaic optimizer according to claim 1, wherein the lower housing comprises a bottom plate, the circuit board is fastened to a surface that is of the bottom plate and that is close to the upper housing, a distance between the bottom of the overflow glue groove and the bottom plate in a first direction is greater than or equal to a distance between a surface that is of the upper housing and that is close to the bottom plate and the bottom plate in the first direction, and the first direction is perpendicular to the bottom plate.

4. The photovoltaic optimizer according to claim 1 or 2, wherein at least a part of a side wall of the overflow glue groove is in contact with the cavity, the part that is of the side wall of the overflow glue groove and that is in contact with the cavity comprises at least one air exhaust hole, and the at least one air exhaust hole communicates the cavity with the overflow glue groove.

5. The photovoltaic optimizer according to any one of claims 1 to 4, wherein the upper housing or the lower housing further comprises a glue filling hole, and the glue filling hole is configured to fill the cavity with potting glue.

6. The photovoltaic optimizer according to claim 5, wherein a scale is provided on an inner side wall of the overflow glue groove; and the scale is for determining whether the cavity has been filled up with the potting glue, or the scale is for determining whether the potting glue has covered the circuit board.

7. The photovoltaic optimizer according to any one of claims 1 to 6, wherein a plurality of heat sinks are disposed on a side that is of the lower housing and that is away from the upper housing.

8. The photovoltaic optimizer according to any one of claims 1 to 3, wherein a circuit board bracket is disposed on a surface that is of the bottom plate and that is close to the upper housing, and the circuit board bracket is configured to install the circuit board.

9. The photovoltaic optimizer according to any one of claims 1 to 8, wherein the upper housing and the lower housing form a package housing of the photovoltaic optimizer, and at least one through hole is provided on a side wall of the package housing; and
the photovoltaic optimizer further comprises at least one cable, one end of the at least one cable is connected to the circuit board, the other end of the at least one cable passes through the at least one through hole and extends to external space of the package housing, and the at least one cable is in a one-to-one correspondence with the at least one through hole.

10. A package housing, comprising:
an upper housing and a lower housing, wherein a cavity is formed between the upper housing and the lower housing; and
the upper housing comprises an overflow glue groove, an opening of the overflow glue groove is located on a side that is of the upper housing and that is away from the lower housing, at least one overflow glue hole is provided at a bottom of the overflow glue groove, and the at least one overflow glue hole communicates the cavity with the overflow glue groove.

11. The package housing according to claim 10, wherein the lower housing comprises a bottom plate, a distance between the bottom of the overflow glue groove and the bottom plate in a first direction is greater than or equal to a distance between a surface that is of the upper housing and that is close to the bottom plate and the bottom plate in the first direction, and the first direction is perpendicular to the bottom plate.

12. The package housing according to claim 10 or 11, wherein at least a part of a side wall of the overflow glue groove is in contact with the cavity, the part that is of the side wall of the overflow glue groove and that is in contact with the cavity comprises at least one air exhaust hole, and the at least one air exhaust hole communicates the cavity with the overflow glue groove.

13. The package housing according to any one of claims 10 to 12, wherein the upper housing or the lower housing further comprises a glue filling hole, and the glue filling hole is configured to fill the cavity with potting glue.

14. The package housing according to claim 13, wherein a scale is provided on an inner side wall of the overflow glue groove; and the scale is for determining whether the cavity has been filled up with the potting glue, or the scale is for determining whether the potting glue has covered the circuit board.

15. An electronic device, comprising a circuit board and the package housing according to any one of claims 10 to 14, wherein the circuit board is disposed in the cavity of the package housing.

16. The package housing according to claim 15, wherein the package housing comprises the upper housing and the lower housing, the cavity is formed between the upper housing and the lower housing, the lower housing comprises the bottom plate, the circuit board is fastened to a side that is of the bottom plate and that is close to the upper housing, the distance between the bottom of the overflow glue groove and the bottom plate in the first direction is greater than or equal to a distance between the circuit board and the bottom plate in the first direction, and the first direction is perpendicular to the bottom plate.
